(19) Europäisches Patentamt
European Patent Office
Office européen des brevets

(11) **EP 1 206 045 B1**

(12) **FASCICULE DE BREVET EUROPEEN**

(45) Date de publication et mention de la délivrance du brevet:
**23.05.2007 Bulletin 2007/21**

(51) Int Cl.:
***H04B 1/707*** *(2006.01)*

(21) Numéro de dépôt: **01402696.7**

(22) Date de dépôt: **18.10.2001**

(54) **Procédé de correction de l'erreur de frequence**

Verfahren zum Korrigieren der Frequenzfehler

Method of correcting frequency error

(84) Etats contractants désignés:
**AT BE CH CY DE DK ES FI FR GB GR IE IT LI LU MC NL PT SE TR**

(30) Priorité: **10.11.2000 FR 0014476**

(43) Date de publication de la demande:
**15.05.2002 Bulletin 2002/20**

(73) Titulaire: **TCL & ALCATEL MOBILE PHONES LIMITED**
**China Hong Kong City,**
**33 Canton Road,**
**Tsim Sha Tsui,Kowloon,**
**Hong Kong (CN)**

(72) Inventeurs:
• **Sanchez, Javier**
  **92500 Rueil Malmaison (FR)**
• **Da Rocha, Alexandre**
  **Santa Clara, CA 95050 (FR)**
• **Perrin, Jean-Hugues**
  **95100 Argenteuil (FR)**

(74) Mandataire: **Feray, Valérie et al**
**Feray Lenne Conseil**
**39/41, avenue Aristide Briand**
**92163 Antony (FR)**

(56) Documents cités:
**EP-A- 0 812 066          EP-A- 0 849 887**
**WO-A-00/38343          WO-A-99/59259**
**US-A- 5 659 573**

• **SAITO S ET AL: "Performance of QPSK coherent detection with dual-mode carrier recovery circuit for fast and stable carrier tracking" IEEE INTERNATIONAL CONFERENCE ON COMMUNICATIONS '88: DIGITAL TECHNOLOGY - SPANNING THE UNIVERSE. CONFERENCE RECORD (CAT. NO.88CH2538-7), PHILADELPHIA, PA, USA, 12-15 JUNE 1988, pages 735-741, XP002173134 1988, New York, NY, USA, IEEE, USA**

**Description**

La présente invention concerne un procédé de correction de l'erreur de fréquence dans un réseau de communication mobile du type CDMA, acronyme pour l'expression anglo-saxonne « Code Division Multiple Access », où le nombre d'utilisateurs pour une station de base est intimement lié au contrôle de puissance dans le réseau.

L'invention se rapporte plus particulièrement au domaine des télécommunications et notamment au domaine des terminaux de radiocommunication.

Le problème qui se pose est celui de l'estimation de l'erreur de fréquence et de sa correction dans un réseau de communication du type CDMA. L'erreur de fréquence est due à divers phénomènes physiques qui interviennent dans le quartz d'un oscillateur d'un terminal de radiocommunication mobile provoquant ainsi un décalage de fréquence. Ces phénomènes peuvent être liés à la température, à la dégradation atomique du quartz au cours du temps etc.

Du fait de ces phénomènes, l'oscillateur du terminal de radiocommunication mobile n'est donc pas toujours synchronisé avec celui de la station de base. Une erreur de fréquence est alors susceptible de provoquer une dégradation des performances de la démodulation qui permet de récupérer l'information binaire et par conséquent, peut provoquer une perte de l'information. De plus, l'erreur de fréquence a un impact direct sur les performances de l'estimation de canal de propagation.

Ainsi, dans le but d'obtenir une bonne synchronisation de fréquence entre la station de base et le terminal de radiocommunication mobile, un quartz très précis peut être utilisé au sein de l'oscillateur local du terminal. Cependant, plus le quartz est précis, plus il est cher. Un oscillateur pourvu d'un tel quartz est donc d'un coût trop élevé pour pouvoir envisager son utilisation dans la fabrication en série de terminaux de radiocommunication mobiles.

Une autre approche consiste à mettre en oeuvre une correction de l'erreur de fréquence pour ce qui concerne la partie bande de base du signal, c'est-à-dire la partie numérique du signal, tout en maintenant pour le traitement du signal en radiofréquence un oscillateur local à faible coût utilisant un quartz classique. Dans ce contexte particulier, où la présente invention se situe, des techniques bien connues de correction de la fréquence existent déjà. Ces techniques peuvent être séparées en deux types.

D'une part, on trouve les techniques basées sur l'analyse dans le domaine fréquentiel qui consiste à mettre en évidence les différentes fréquences d'un signal complexe et à déterminer l'amplitude et la phase des signaux partiels correspondants. Un spectre de puissances est ainsi calculé par l'intermédiaire d'une opération de transformation de Fourier rapide. A partir de l'estimation du spectre de puissance obtenue, une évaluation du décalage du spectre par rapport à la référence de fréquence à 0 hertz est réalisée. Il s'agit alors de centrer le spectre dans le but de compenser le décalage dû à l'erreur fréquentielle. Enfin, une opération de transformation de Fourier rapide inverse est appliquée pour retourner dans le domaine temporel et ainsi poursuivre le traitement du signal correspondant.

D'autre part, on trouve des techniques de correction de l'erreur de fréquence basée sur une analyse temporelle. L'erreur de fréquence est calculée à partir d'un canal commun où l'information transportée est connue par le terminal mobile. La correction est alors appliquée symbole par symbole sur le signal d'entrée. Cette étape implique de mettre en oeuvre un produit complexe entre l'erreur de fréquence et le signal d'entrée. Un tel produit implique donc un calcul par l'intermédiaire de fonctions sinus et cosinus.

Le document XP010072149 de Saito S. et Suzuki H. - "Performance of QPSK cohérent detection with dual-mode carrier recovery circuit for fast and stable carrier tracking" présenté à la "DIGITAL TECHNOLOGY - SPANNING THE UNIVERSE. PHILADELPHIA, JUNE 12 - 15, 1988, INTERNATIONAL CONFERENCE ON COMMUNICATIONS, NEW YORK, IEEE, US" décrit un récepteur ou l'estimation de la porteuse est réalisée en deux modes distincts, "Costas loop" ou "adaptive carrier tracking - ACT", les deux modes étant choisis en fonction du rapport porteuse à bruit du signal à démoduler.

Le principal inconvénient des techniques de correction de l'erreur de fréquence exposées ci-dessus est la complexité de calcul très importante qu'elles entraînent lorsqu'elles sont mises en oeuvre sur un terminal mobile du type CDMA. De plus, aucune de ces solutions n'est prévu pour prendre également en compte le problème du filtrage des estimations de canal.

Ainsi, l'invention se propose de pallier les inconvénients de l'état de la technique précités en fournissant un procédé de correction de l'erreur de fréquence destiné à être mis en oeuvre sur des terminaux de radiocommunication mobiles du type CDMA qui soit adaptatif selon la valeur de l'erreur de fréquence, de façon à réguler la complexité de calcul. Ainsi, trois modes de correction pour la correction de l'erreur de fréquence sont prévues par l'invention. Un mode en boucle fermée qui correspond à une correction de l'erreur de fréquence très précise, un mode en boucle ouverte qui correspond à une correction grossière et enfin, un mode avec une absence totale de correction de fréquence. Ce système permet d'adapter la complexité des calculs mis en oeuvre lors de la correction de l'erreur de fréquence selon les besoins, tout en gardant intacts les performances en terme de démodulation.

L'invention concerne donc un procédé de correction de l'erreur de fréquence apparue dans un signal d'entrée d'un récepteur d'un terminal de radiocommunication mobile, caractérisé en ce qu'il consiste à mettre en oeuvre l'un des trois modes distincts de traitement de l'erreur de fréquence qui correspondent respectivement à un mode de traitement sans aucune correction de l'erreur de fréquence, à un mode de traitement en boucle ouverte pour une correction grossière de l'erreur de fréquence et un mode de traitement en boucle fermée pour une correction précise de l'erreur de fréquence, le mode de traitement de l'erreur de fréquence étant sélectionnés par une unité de contrôle centrale en fonction d'une part, de la valeur de l'erreur de fréquence et, d'autre part, d'un facteur de qualité déterminé par une unité de contrôle de qualité d'un bloc de filtrage des coefficients de canal.

Une autre caractéristique du procédé selon l'invention est qu'il comprend une étape préalable consistant à estimer l'erreur de fréquence apparue dans le signal d'entrée à partir de la réponse impulsionnelle du canal de propagation dudit signal d'entrée, ladite estimation de l'erreur de fréquence étant mise en oeuvre par l'intermédiaire d'une estimation d'erreur de phase.

Selon un mode de réalisation particulier de l'invention, l'estimation de l'erreur de fréquence est mise en oeuvre avec une périodicité variable.

L'erreur de fréquence estimée est prévue pour être filtrée selon une pluralité d'estimations de l'erreur de fréquence de façon à obtenir une erreur de fréquence moyennée.

Le rôle du facteur de qualité est de contrôler l'efficacité du filtrage des coefficients de canal.

Pour cela, le facteur de qualité est déterminé en fonction d'un rapport signal sur interférences.

L'invention concerne également un dispositif de correction de l'erreur de fréquence apparue dans un signal d'entrée multi-trajets d'un récepteur d'un terminal de radiocommunication mobile (REC) apte à communiquer avec un émetteur distant par l'intermédiaire d'un canal de propagation, caractérisé en ce qu'il comprend une unité de contrôle centrale prévue pour mettre en oeuvre trois modes distincts de traitement de l'erreur de fréquence qui correspondent respectivement à un mode de traitement sans aucune correction de l'erreur de fréquence, à un mode de traitement en boucle ouverte pour une correction grossière de l'erreur de fréquence et un mode de traitement en boucle fermée pour une correction précise de l'erreur de fréquence, le mode de traitement étant sélectionné en fonction d'une part de la valeur de l'erreur de fréquence et, d'autre part, d'un facteur de qualité déterminé par une unité de contrôle de qualité d'un bloc de filtrage des coefficients de canal.

Un bloc d'estimation de l'erreur de fréquence associé à un bloc de filtrage de l'estimation de l'erreur de fréquence sont prévus pour fournir la valeur de l'erreur de fréquence à l'unité de contrôle centrale.

Le dispositif selon l'invention comprend en plus pour la mise en oeuvre de la correction grossière de l'erreur de fréquence, d'une part un bloc de correction des estimations de canal prévu pour fournir au bloc de filtrage de canal une réponse impulsionnelle du canal de propagation exempte de l'erreur de fréquence et, d'autre part, un bloc de traitement de la réponse impulsionnelle du canal de propagation prévu pour réintroduire l'erreur de fréquence dans la réponse impulsionnelle du canal de propagation filtrée.

Enfin, le dispositif selon la présente invention se caractérise en ce qu'il comprend en plus, pour la mise en oeuvre de la correction précise de l'erreur de fréquence, une boucle fermée constituée d'un bloc de filtrage de l'erreur de fréquence moyennée associé à un bloc de correction de fréquence, lequel bloc de correction de fréquence reçoit en entrée le signal multi-trajets et fournit en sortie un signal multi-trajets exempt de l'erreur de fréquence.

D'autres caractéristiques et avantages de l'invention apparaîtront plus clairement à la lecture de la description suivante d'un exemple particulier de réalisation en référence aux figures dans lesquelles :

- la figure 1 est un schéma bloc d'un récepteur de type râteau, connu sous l'expression anglo-saxonne « rake », dans un système de radiocommunication mobile, dans le cas où aucune correction de la fréquence n'est mise en oeuvre;
- la figure 2 est un schéma bloc d'un récepteur dans le cas où une correction de la fréquence en boucle ouverte est mise en oeuvre.
- la figure 3 est un schéma bloc d'un récepteur dans le cas où une correction de la fréquence en boucle fermée est mise en oeuvre;

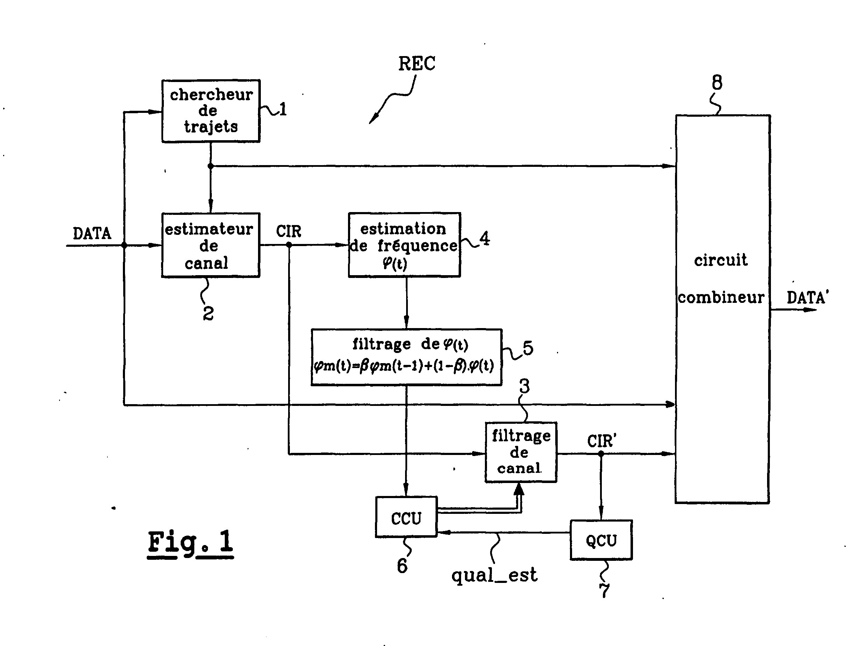

Les figures 1, 2 et 3 décrivent chacune un mode de traitement de l'erreur de fréquence parmi les trois modes de traitement exclusifs du procédé de correction de l'erreur de fréquence selon la présente invention. Elles illustrent donc les trois scénari prévus par le procédé selon l'invention. Tous les blocs et éléments en commun aux figures 1, 2 et 3 ont gardé la même référence.

Sur la figure 1, un signal d'entrée comprenant les données utiles émises par un émetteur distant, dit par la suite signal data est appliqué à la borne d'entrée d'un récepteur d'un terminal de radiocommunication mobile REC. Il est fourni à une borne d'entrée d'un circuit chercheur de trajets 1, à une première borne d'entrée d'un estimateur de canal 2, ainsi qu'à une première borne d'entrée d'un circuit combineur 8. Le signal data est un signal multi-trajets. Le circuit chercheur de trajets 1 comprend une borné de sortie connectée à une deuxième borne d'entrée de l'estimateur de canal 2 et à une deuxième borne d'entrée du circuit combineur 8.

L'estimateur de canal 2 comprend une borne de sortie connectée, d'une part à une première borne d'entrée d'un bloc 3 de filtrage de canal et, d'autre part, à une borne d'entrée d'un bloc 4 d'estimation de l'erreur de fréquence. Le bloc 3 de filtrage de canal comprend une borne de sortie connectée d'une part, à une troisième borne d'entrée du circuit combineur 8 et, d'autre part à une borne d'entrée d'une unité de contrôle de qualité ou QCU 7.

Le bloc 4 d'estimation de l'erreur de fréquence comprend une borne de sortie connectée à une borne d'entrée d'un bloc 5 de filtrage de l'estimation de l'erreur de fréquence. Le bloc 5 de filtrage de l'estimation de l'erreur de fréquence comprend une borne de sortie connectée à une première borne d'entrée d'une unité de contrôle centrale ou CCU 6. L'unité de contrôle centrale 6 comprend une seconde borne d'entrée reliée à la borne de sortie de l'unité de contrôle de qualité 7. L'unité de contrôle centrale 6 fournit un signal de commande au bloc de filtrage de canal 3.

Le signal radioélectrique se propage suivant un ou plusieurs trajets qui sont dus à des obstacles sur lesquels les ondes ricochent avant d'atteindre leur destination. Elles arrivent donc avec des phases différentes.

De plus, les ondes arrivant en retard ont parcouru un chemin plus long, leur amplitude peut par conséquent être davantage atténuée.

Le signal arrive donc distordu en phase et éventuellement en amplitude au niveau du terminal de radiocommunication mobile.

Le rôle du circuit chercheur de trajets 1 est alors d'estimer les retards dans la transmission des signaux dus au phénomène de multi-trajet expliqué ci-dessus. Pour ce faire, le circuit chercheur de trajets 1 met en oeuvre une estimation de puissance pour chacun des trajets permettant ainsi de déduire les retards. Le circuit chercheur de trajet 1 reçoit en entrée le signal data multi-trajets et fournit en sortie, après traitement effectué de manière connue dans l'état de la technique par divers algorithmes, le profil en puissance du signal data sur un certain temps.

Une fois que les différents retards ont pu être déterminés grâce au traitement mis en oeuvre par le circuit chercheur de trajets 1, l'estimateur de canal 2 entre en action afin de fournir une estimation de la réponse impulsionnelle du canal de propagation. En d'autres termes, l'estimateur de canal 2 a pour fonction de déterminer les amplitudes et les phases de chaque trajet. Une estimation de canal est effectuée tous les slots. Un « slot » est une expression anglo-saxonne communément utilisée pour déterminer une tranche de temps et correspond dans notre contexte à 0,6 milliseconde.

Pour fournir l'estimation de la réponse impulsionnelle du canal de propagation, il est nécessaire que l'estimateur de canal 7 reçoive en entrée d'une part, le signal multi-trajets data et, d'autre part, les retards calculés par le circuit chercheur de trajets 1. En effet, pour déterminer l'amplitude et la phase du signal pour chaque trajet, l'estimateur de canal 2 doit connaître la valeur du retard de chaque trajet. L'amplitude et la phase pour chaque trajet sont alors représentées par un coefficient complexe. L'ensemble des coefficients représentant l'amplitude et la phase pour chaque trajet constitue la réponse impulsionnelle du canal de propagation CIR (« Channel Impulse Response » en langue anglo-saxonne).

En sortie de l'estimateur de canal 2, le signal CIR est alors fourni au bloc 4 d'estimation de fréquence. Le bloc 4 a donc pour rôle de déterminer l'erreur de fréquence instantanée. Concrètement, l'erreur de fréquence se traduit par une rotation du signal multi-trajets avec un incrément de phase continu noté φ. Le problème de l'estimation de l'erreur de fréquence peut donc être traité comme un problème d'estimation de l'erreur de phase.

L'erreur de phase instantanée φ(t) est calculée dans le bloc 4 à partir de la différence de phase entre deux estimations de canal consécutives obtenues aux temps t et t+1. Ainsi, tous les slots, l'erreur de phase est estimée.

Selon un mode de réalisation préféré de l'invention, l'estimation de l'erreur de phase causée par l'erreur de fréquence s'effectue sur le trajet le plus puissant, c'est-à-dire le trajet pour lequel la puissance reçue est la plus grande.

Cependant, dans le cadre de la norme UMTS mode FDD, où UMTS est l'acronyme pour l'expression anglo-saxonne « Universal Mobile Telecommunication System » et FDD est l'acronyme pour l'expression anglo-saxonne « Frequency Division Duplex », dix estimations de canal sont effectuées par slot et sont ensuite moyennées.

Dans le cadre de cette norme, l'estimation de canal pour chaque slot correspond donc à une moyenne de 10 estimations de canal. La valeur de φ(t) est alors estimée sur cette valeur moyenne. Or, sur un slot, l'erreur de fréquence peut déjà être d'une importance telle qu'il est impossible de récupérer l'information.

Ainsi, selon un autre mode de réalisation de l'invention, l'erreur de phase peut être calculée avec une périodicité variable. La valeur de φ(t) peut alors être estimée non pas au bout de dix valeurs d'estimation de canal, mais au bout de cinq valeurs d'estimation de canal par exemple.

L'erreur de phase instantanée φ(t), représentative de l'erreur de fréquence, est ensuite filtrée dans le bloc 5 de filtrage de manière à éliminer les erreurs de phases aléatoires ou bien les erreurs de phase qui sont dus à l'effet Doppler. L'erreur de phase instantanée φ (t) est donc moyennée sur plusieurs estimations par l'intermédiaire d'un filtre passe-bas classique dont l'équation est la suivante :

$$\varphi m(t) = \beta . \varphi m(t-1) + (1-\beta) . \varphi(t), \text{ où } 0 < \beta < 1$$

L'erreur de phase moyennée φm(t), qui traduit l'erreur de fréquence moyenne, est alors fournie à la CCU 6 qui détermine si l'erreur de phase est suffisamment importante pour nuire aux performances de la démodulation. Ainsi, l'association du bloc 4 d'estimation de l'erreur de fréquence et du bloc 5 de filtrage de l'estimation de l'erreur de fréquence permet de fournir la valeur de l'erreur de fréquence à l'unité de contrôle centrale 6.

Dans le cas où l'erreur de phase φm(t) n'est pas considérée comme étant suffisamment importante par la CCU, un mode de traitement sans correction de l'erreur de fréquence est appliqué. L'unité de contrôle centrale 6 envoie alors un signal de commande à destination du bloc de filtrage des coefficients de canal 3 pour lui signifier de ne pas tenir compte de l'erreur de fréquence. Le filtrage des estimations de canal dans le bloc de filtrage 3 permet de prendre en compte l'effet Doppler, c'est-à-dire l'erreur d'estimation des coefficients de canal due à la vitesse de déplacement du terminal de radiocommunication. Ainsi, le bloc de filtrage de canal 3 filtre les estimations de canal en fonction de la vitesse du terminal de radiocommunication. Dans ce mode de traitement sans correction, on considère que le décalage due à l'erreur de fréquence qui s'ajoute à l'effet Doppler n'est pas gênant.

La CCU commande alors de mettre en oeuvre un filtrage de canal parmi un nombre restreint de possibilités : vitesse de déplacement élevée, vitesse de déplacement moyenne, vitesse de déplacement faible et enfin absence totale de filtrage de canal.

Le bloc 3 de filtrage des estimations de canal met donc en oeuvre le filtrage des coefficients de canal issus de l'estimateur de canal 2. Ce filtrage permet d'obtenir les coefficients de canal filtrés et ainsi d'atténuer les erreurs d'estimation des coefficients de canal dus à l'effet Doppler. Le bloc 3 fournit en sortie une réponse impulsionnelle de canal améliorée CIR' qui tient compte de la vitesse de déplacement du terminal de radiocommunication mobile. Le signal CIR' est alors fourni d'une part, au circuit combineur 8 et, d'autre part, à l'unité de contrôle de qualité 7.

L'unité de contrôle de qualité 7 a pour rôle de déterminer un facteur de qualité des estimations de canal filtrés qual_est qui est fonction du rapport signal sur interférences SIR. Le facteur de qualité qual_est permet de contrôler l'efficacité du filtrage des coefficients de canal réalisé dans le bloc de filtrage 3. Le facteur de qualité qual_est est fourni par la QCU 7 à la CCU 6, qui va également tenir compte de ce paramètre pour décider de mettre en oeuvre le mode de traitement de l'erreur de fréquence sans aucune correction.

Pour mettre en oeuvre le mode de traitement de l'erreur de fréquence, la CCU se base donc d'une part, sur la valeur de l'erreur de fréquence, représentée par l'erreur de phase moyennée φm(t), et, d'autre part sur la valeur du facteur de qualité qual_est.

Le circuit combineur 10 combine alors tous les trajets en un seul trajet de façon cohérente, c'est-à-dire en corrigeant les erreurs de phase et les retards. Le circuit combineur 10 va retarder les signaux qui arrivent en premier pour prendre ensuite en compte ceux qui arrivent en retard, de manière à pouvoir les combiner tous en même temps en corrigeant les phases. Pour ce faire, le circuit combineur 8 effectue un produit complexe entre le signal data et la valeur conjuguée de la réponse impulsionnelle filtrée du canal de propagation CIR'. Il fournit en sortie un signal data' renforcé en puissance.

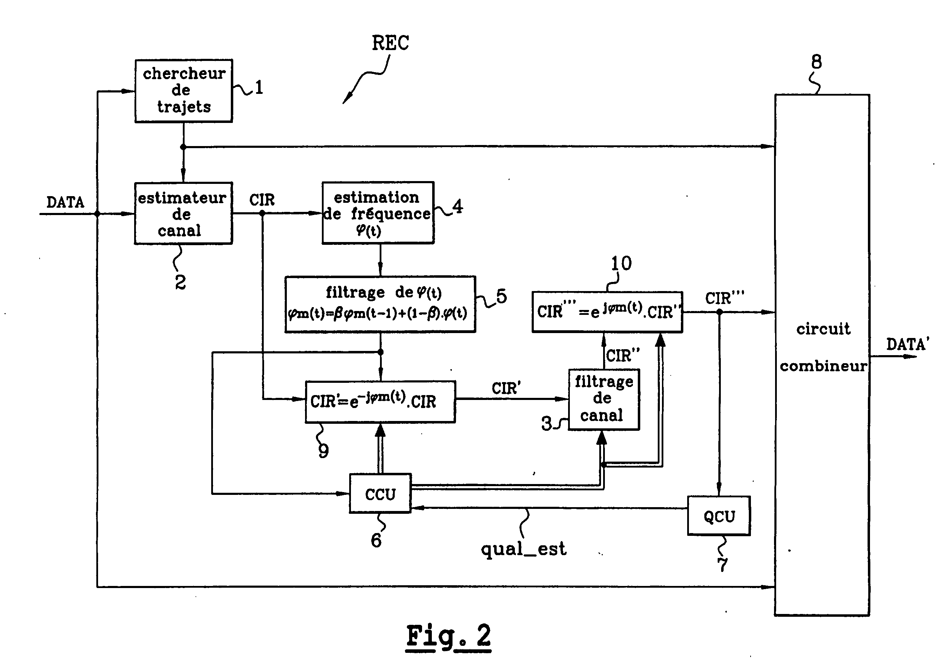

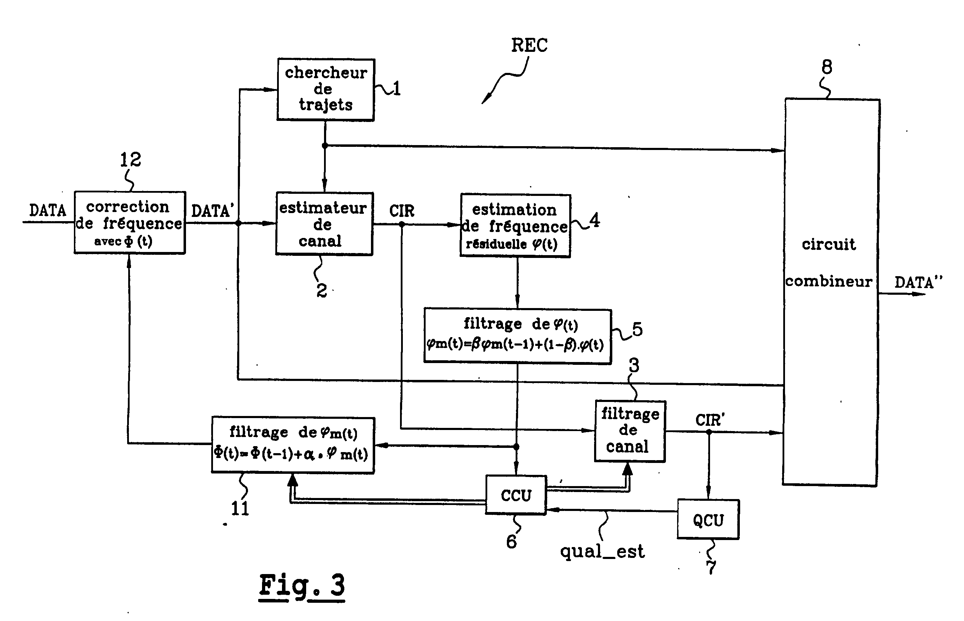

Cependant, dans le cas où l'erreur de fréquence est suffisamment importante pour qu'il soit nécessaire d'envisager une correction de la fréquence, la CCU 6 peut commander de mettre en oeuvre un mode de traitement de l'erreur de fréquence en boucle ouverte, qui correspond à une correction grossière de l'erreur de fréquence. Ce mode de traitement de l'erreur de fréquence en boucle ouverte est décrit en référence à la figure 2. Il correspond à une complexité de calcul intermédiaire par rapport au mode de traitement précédent de l'erreur de fréquence où aucune correction n'était envisagée et par rapport au mode de traitement qui sera vu plus tard en liaison avec la figure 3 qui met en oeuvre une correction très précise de l'erreur de fréquence en boucle fermée.

Ainsi, entre l'estimateur de canal 2 et le bloc de filtrage de canal 3, se trouve un bloc 9 de correction des estimations de canal. Ce bloc 9 reçoit en entrée d'une part, le signal CIR, issu de l'estimateur de canal 2, représentant la réponse impulsionnelle du canal de propagation et, d'autre part, l'erreur de phase moyennée φm(t), issue du bloc de filtrage de φ(t) 5. Le bloc 9 fournit en sortie un signal CIR' corrigé au bloc de filtrage de canal 3.

Un bloc de traitement de la réponse impulsionnelle du canal de propagation 10 reçoit en entrée un signal CIR'' en provenance du bloc de filtrage de canal 3 et fournit en sortie un signal CIR''' au circuit combineur 8.

Enfin, la CCU 6 fournit un signal de commande aux blocs 9, 3 et 10.

En effet, La CCU reçoit, comme lors du traitement précédent sans correction vu en référence à la figure 1, la valeur de l'erreur de phase moyennée φm(t) de la part du bloc de filtrage de φ(t) 5. Dans ce mode de traitement en boucle ouverte, la CCU estime que l'erreur de phase φm(t) est suffisamment importante pour nécessiter une correction de fréquence. La CCU envoie alors un signal de commande à destination du bloc de correction 9.

La correction de l'erreur de fréquence consiste à effectuer un produit complexe entre les coefficients de l'estimation de canal CIR et le complexe $e^{-j\,\varphi m(t)}$. Le produit complexe $e^{-j\varphi m(t)}*CIR$ permet ainsi de remettre en phase les coefficients de canal par rapport à l'erreur de phase moyennée φm(t), de manière à ce que le filtrage des coefficients de canal dans le bloc 3 ne soit pas perturbé par l'erreur de fréquence et ne prenne en compte que l'effet Doppler. Le bloc 9 permet de retirer la contribution de l'erreur de fréquence dans la réponse impulsionnelle du canal de propagation CIR. Le bloc 9 fournit donc en sortie au bloc de filtrage 3, la réponse impulsionnelle du canal de propagation exempte de l'erreur de fréquence CIR'.

Il faut noter que ce mode de traitement applique sans distinction la même erreur de phase φm(t) à tous les symboles qui sont dans le slot lorsque les coefficients de canal sont remis en phase dans le bloc 9. En effet, φm(t) correspond à une estimation moyenne sur tous les slots. Le mode de traitement en boucle ouverte met donc en oeuvre une correction grossière de l'erreur de fréquence, mais qui s'avère néanmoins suffisante dans de nombreux cas déterminés par la CCU.

La réponse impulsionnelle CIR' du canal remise en phase par l'intermédiaire du bloc 9 est alors fournie au bloc de filtrage de canal 3 qui, après réception du signal de commande émis par la CCU, va filtrer les coefficients de canal pour tenir compte de l'effet Doppler. Le signal CIR'' en sortie du bloc de filtrage de canal 3 correspond donc à la réponse impulsionnelle du canal de propagation filtrée tenant compte d'une part, de l'erreur de phase et, d'autre part, de l'erreur due à l'effet Doppler.

Le signal CIR'' est alors fourni au bloc de traitement 10 dont le rôle est de réintroduire l'erreur de phase, représentative de l'erreur de fréquence, dans le signal CIR'' afin que le circuit combineur 10 en prenne compte. En effet, le circuit combineur 10 effectue par la suite un produit complexe entre le signal data et les coefficients de canal filtrés pour fournir en sortie un signal data' renforcé en puissance.

Le bloc 10, sous l'impulsion d'un signal de commande émis par la CCU, effectue donc un produit complexe entre les coefficients filtrés du signal CIR'' et le complexe $e^{j \phi m(t)}$. Le produit complexe $e^{j \phi m(t)}*CIR''$ permet d'obtenir une réponse impulsionnelle CIR''' où l'erreur de phase a été réintroduite. Le traitement dans le circuit combineur 8 peut alors être effectué sans erreur.

Enfin, la QCU, sur la base du signal CIR''', va déterminer le facteur de qualité qual_est en fonction du rapport signal sur interférences. Le facteur de qualité qual_est permet de vérifier l'efficacité du filtrage de canal et est fourni à la CCU. Le rebouclage de la QCU sur la CCU procure donc un contrôle supplémentaire du système et permet ainsi d'affiner le mode de traitement de l'erreur de fréquence à mettre en oeuvre.

Enfin, un dernier mode de traitement proposé par l'invention est le mode de traitement en boucle fermée illustré à la figure 3. Ce mode de traitement permet de prendre en compte les erreurs de fréquence importantes qui nécessitent une correction très précise. Il correspond donc au mode de traitement le plus performant mais il entraîne une complexité de calcul plus élevée que les modes de traitement précédents.

En effet, par rapport au schéma de la figure 1, le schéma de la figure 3 comprend une boucle fermée constituée d'un bloc 11 de filtrage de l'erreur de fréquence moyennée φm(t) associé à un bloc 12 de correction de fréquence. Le bloc 11 reçoit sur une première borne d'entrée, un signal issu du bloc 5 de filtrage de l'erreur de phase instantanée φ(t) et, sur une seconde borne d'entrée, un signal de commande issu de la CCU 6.

Le bloc 11 comprend une borne de sortie connectée à une première borne d'entrée du bloc 12 de correction de fréquence. Le bloc 12 de correction de fréquence comprend une seconde borne d'entrée sur laquelle est fourni le signal data. Le bloc 12 comprend enfin une borne de sortie fournissant un signal data' connectée d'une part, à une borne d'entrée de l'estimateur de canal 2 et, d'autre part à une borne d'entrée du circuit combineur 8.

Comme précédemment, la CCU 6 reçoit d'une part, la valeur de l'erreur de phase moyennée φm(t) du bloc de filtrage 5 et, d'autre part, la valeur du facteur de qualité qual_est calculé par la QCU 7. Lorsque ces valeurs dépassent un certain seuil prédéterminé qui implique une dégradation trop importante en terme de démodulation, la CCU commande l'application du mode de traitement en boucle fermée.

La CCU fournit alors un signal de commande au bloc de filtrage 11 pour lancer le processus de traitement de l'erreur de fréquence en boucle fermée. Le traitement de l'erreur de fréquence en boucle fermée se poursuit jusqu'à ce que la boucle converge. Le temps de convergence de la boucle est de l'ordre de quelques milli-seconde.

Le bloc 11 filtre l'erreur de phase moyennée φm(t) selon l'équation de filtre suivante :

$$\phi(t)=\phi(t-1)+\alpha.\phi m(t), \text{ avec } 0 \leq \alpha \leq 1$$

La valeur de α est déterminée par la CCU en fonction de la vitesse de convergence que l'on souhaite avoir dans la boucle.

La valeur de φ(t) est alors fournie au bloc de correction de fréquence 12 qui effectue un produit complexe entre la valeur $e^{-j\phi(t)}$ et le signal complexe data de manière à le remettre en phase. Contrairement au mode de traitement en boucle ouverte, la correction de fréquence est réalisée directement sur le signal data, et non à partir de la réponse impulsionnelle du canal de propagation. La correction de fréquence est donc mise en oeuvre symbole par symbole, ce qui fait que tous les symboles sont remis en phase. Le traitement en boucle fermée est donc très précis même s'il est plus coûteux que les deux premiers traitements en terme de complexité de calcul.

En sortie du bloc de correction 12, le signal data' est fourni à l'estimateur de canal 2 qui va fournir la réponse impulsionnelle du canal de propagation CIR sur la base de ce signal data' exempt de l'erreur de fréquence. Une estimation de l'erreur de fréquence résiduelle est alors mise en oeuvre par l'intermédiaire du bloc d'estimation de l'erreur de fréquence résiduelle 4 sur la base de la réponse impulsionnelle du canal CIR. Cette estimation de l'erreur résiduelle est filtrée dans le bloc de filtrage 5, puis fournie à la CCU. La CCU commande la poursuite du traitement en boucle fermée jusqu'à la disparition de l'erreur de fréquence résiduelle.

Lorsque la boucle a convergé, le signal data' est propre en ce qui concerne l'erreur de fréquence. Le traitement classique du signal data' par le circuit chercheur de trajets 1 et l'estimateur de canal 2 a lieu comme si il n'y avait pas d'erreur de fréquence. Les coefficients de canal sont alors filtrés par le bloc de filtrage de canal 3 sous l'impulsion d'un signal de commande émis par la CCU. Le circuit combineur 8 peut alors effectuer son traitement sur le signal data' et fournit en sortie un signal data'' renforcé en puissance.

Le procédé selon l'invention permet donc de gérer deux problèmes en même temps : la correction de l'erreur de fréquence et le filtrage de l'estimation de canal. En effet, il permet de s'affranchir du décalage de fréquence, dû à l'erreur de fréquence, qui vient s'ajouter à l'effet Doppler, dégradant ainsi l'efficacité du filtrage de canal. Le procédé selon l'invention permet de trouver un compromis optimal entre la complexité de calcul que nécessite la correction de l'erreur de fréquence et les performances en terme de démodulation. En effet, la performance du démodulateur est intimement liée au choix du filtrage de canal et à la précision de la correction de fréquence.

## Revendications

1.  Procédé de correction de l'erreur de fréquence apparue dans un signal d'entrée multi-trajets (data) d'un récepteur d'un terminal de radiocommunication mobile (REC), **caractérisé en ce qu'**il consiste à mettre en oeuvre l'un des trois modes distincts de traitement de l'erreur de fréquence qui correspondent respectivement à un mode de traitement sans aucune correction de l'erreur de fréquence, à un mode de traitement en boucle ouverte pour une correction grossière de l'erreur de fréquence et un mode de traitement en boucle fermée pour une correction précise de l'erreur de fréquence, le mode de traitement de l'erreur de fréquence étant sélectionnés par une unité de contrôle centrale (6) en fonction d'une part, de la valeur de l'erreur de fréquence et, d'autre part, d'un facteur de qualité (qual_est) déterminé par une unité de contrôle de qualité (7) d'un bloc de filtrage des coefficients de canal (3).

2.  Procédé selon la revendication 1, **caractérisé en ce qu'**il comprend une étape préalable consistant à estimer l'erreur de fréquence apparue dans le signal d'entrée multi-trajets (data) à partir de la réponse impulsionnelle du canal de propagation (CIR) dudit signal d'entrée (data), ladite estimation de l'erreur de fréquence étant mise en oeuvre par l'intermédiaire d'une estimation d'erreur de phase ($\varphi(t)$).

3.  Procédé selon la revendication 2, **caractérisé en ce que** l'estimation de l'erreur de phase causée par l'erreur de fréquence s'effectue sur le trajet le plus puissant.

4.  Procédé selon la revendication 2, **caractérisé en ce que** l'estimation de l'erreur de fréquence est mise en oeuvre avec une périodicité variable.

5.  Procédé selon la revendication 2, **caractérisé en ce que** l'erreur de fréquence estimée est filtrée selon une pluralité d'estimations de l'erreur de fréquence de façon à obtenir une erreur de fréquence moyennée.

6.  Procédé selon la revendication 1, **caractérisé en ce que** le facteur de qualité (qual_est) permet de contrôler l'efficacité du filtrage des coefficients de canal.

7.  Procédé selon la revendication 6, **caractérisé en ce que** le facteur de qualité (qual_est) est déterminé en fonction d'un rapport signal sur interférences.

8.  Dispositif de correction de l'erreur de fréquence apparue dans un signal d'entrée multi-trajets (data) d'un récepteur d'un terminal de radiocommunication mobile (REC) apte à communiquer avec un émetteur distant par l'intermédiaire d'un canal de propagation, **caractérisé en ce qu'**il comprend une unité de contrôle centrale (6) prévue pour mettre en oeuvre trois modes distincts de traitement de l'erreur de fréquence qui correspondent respectivement à un mode de traitement sans aucune correction de l'erreur de fréquence, à un mode de traitement en boucle ouverte pour une correction grossière de l'erreur de fréquence et un mode de traitement en boucle fermée pour une correction précise de l'erreur de fréquence, le mode de traitement étant sélectionné en fonction d'une part de la valeur de l'erreur de fréquence et, d'autre part, d'un facteur de qualité (qual_est) déterminé par une unité de contrôle de qualité (7) d'un bloc de filtrage des coefficients de canal (3).

9.  Dispositif selon la revendication 8, **caractérisé en ce qu'**il comprend un bloc d'estimation de l'erreur de fréquence (4) associé à un bloc de filtrage de l'estimation de l'erreur de fréquence (5) pour fournir la valeur de l'erreur de fréquence à l'unité de contrôle centrale (6).

10. Dispositif selon l'une des revendications 8 ou 9, **caractérisé en ce qu'**il comprend en plus, pour la mise en oeuvre de la correction grossière de l'erreur de fréquence, d'une part un bloc de correction des estimations de canal (9) prévu pour fournir au bloc de filtrage de canal (3) une réponse impulsionnelle du canal de propagation exempte de l'erreur de fréquence (CIR') et, d'autre part, un bloc de traitement de la réponse impulsionnelle du canal de propagation (10) prévu pour réintroduire l'erreur de fréquence dans la réponse impulsionnelle du canal de propagation filtrée (CIR'').

11. Dispositif selon l'une des revendications 8 ou 9 **caractérisé en ce qu'**il comprend en plus, pour la mise en oeuvre de la correction précise de l'erreur de fréquence, une boucle fermée constituée d'un bloc de filtrage de l'erreur de fréquence moyennée (11) associé à un bloc de correction de fréquence (12), lequel bloc de correction de fréquence (12) reçoit en entrée le signal multi-trajets (data) et fournit en sortie un signal multi-trajets exempt de l'erreur de fréquence (data').

## Claims

1. A method for correcting the frequency error having occurred in a multi-path input signal (data) of a receiver of a mobile radiocommunications terminal (REC), **characterized in that** it consists of applying one of the three distinct modes for processing the frequency error which respectively correspond to a processing mode without any correction of the frequency error, to an open loop processing mode for a rough correction of the frequency error and to a closed loop processing mode for accurate correction of the frequency error, the mode for processing the frequency error being selected by a central control unit (6) according to the value of the frequency error on the one hand and according to a quality factor (qual_est) determined by a quality control unit (7) of a channel coefficient filtering block (3) on the other hand.

2. The method according to claim 1, **characterized in that** it comprises a preliminary step consisting of estimating the frequency error having occurred in the multi-path input signal (data) from the impulse response of the propagation channel (CIR) of said input signal (data), said estimation of the frequency error being applied via an estimation of the phase error ($\varphi(t)$).

3. The method according to claim 2, **characterized in that** the estimation of the phase error caused by the frequency error is carried out on the most powerful path.

4. The method according to claim 2, **characterized in that** the estimation of the frequency error is applied with variable periodicity.

5. The method according to claim 2, **characterized in that** the estimated frequency error is filtered according to a plurality of estimations of the frequency error so as to obtain an averaged frequency error.

6. The method according to claim 1, **characterized in that** the efficiency of the filtering of the channel coefficients may be controlled with the quality factor (qual est).

7. The method according to claim 6, **characterized in that** the quality factor (qual_est) is determined according to a signal-on-interferences ratio.

8. A device for correcting the frequency error having occurred in a multi-path input signal (data) of a receiver of a mobile radiocommunications terminal (REC) capable of communicating with a remote transmitter via a propagation channel, **characterized in that** it comprises a central control unit (6) provided for applying three distinct modes for processing the frequency error, which respectively correspond to a processing mode without any correction of the frequency error, to an open loop processing mode for rough correction of the frequency error and to an closed loop processing mode for accurate correction of the frequency error, the processing mode being selected according to the value of the frequency error on the one hand and according to a quality factor (qual_est) determined by a quality control unit (7) of a channel coefficient filtering block (3) on the other hand.

9. The device according to claim 8, **characterized in that** it comprises a block (4) for estimating the frequency error, associated with a block (5) for filtering the estimation of the frequency error in order to provide the value of the frequency error to the central control unit (6).

10. The device according to any of claims 8 or 9, **characterized in that** it further comprises, for applying rough correction of the frequency error, a block (9) for correcting the channel estimations provided for supplying to the channel filtering block (3) an impulse response (CIR') of the propagation channel, free of the frequency error, on the one hand and a block (10) for processing the impulse response of the propagation channel provided for re-introducing the frequency error into the impulse response (CIR") of the filtered propagation channel.

11. The device according to any of claims 8 or 9, **characterized in that** it further comprises, for applying accurate correction of the frequency error, a closed loop consisting of a block (11) for filtering the averaged frequency error, associated with a frequency correction block (12), which frequency correction block (12) receives at its input the multi-path signal (data) and provides at the output a multi-path signal (data') free of the frequency error.

**Patentansprüche**

1. Verfahren zum Korrigieren des Frequenzfehlers, der in einem Mehrweg-Eingangssignal (data) eines Empfängers eines mobilen Funkkommunikationsendgeräts (REC) auftritt, **dadurch gekennzeichnet, dass** es darin besteht, eine von drei verschiedenen Behandlungsweisen für den Frequenzfehler auszuführen, die einer Behandlungsweise ohne jegliche Korrektur des Frequenzfehlers, einer Behandlungsweise mit offener Schleife für eine grobe Korrektur des Frequenzfehlers bzw. einer Behandlungsweise mit geschlossener Schleife für eine genaue Korrektur des Frequenzfehlers entsprechen, wobei die Frequenzfehler-Behandlungsweise durch eine Zentraleinheit (6) in Abhängigkeit einerseits von dem Wert des Frequenzfehlers und andererseits von einem durch eine Qualitätssteuereinheit (7) eines Filterblocks (3) der Kanalkoeffizienten bestimmten Qualitätsfaktor (qual_est) ausgewählt wird.

2. Verfahren nach Anspruch 1, **dadurch gekennzeichnet, dass** es einen vorhergehenden Schritt umfasst, der darin besteht, den in dem Mehrweg-Eingangssignal (data) auftretenden Frequenzfehler anhand der Impulsantwort des Ausbreitungskanals (CIR) des Eingangssignals (data) zu schätzen, wobei die Schätzung des Frequenzfehlers mittels einer Schätzung des Phasenfehlers ($\square$(t)) ausgeführt wird.

3. Verfahren nach Anspruch 2, **dadurch gekennzeichnet, dass** die Schätzung des durch den Frequenzfehler verursachten Phasenfehlers auf dem leistungsstärksten Weg erfolgt.

4. Verfahren nach Anspruch 2, **dadurch gekennzeichnet, dass** die Schätzung des Frequenzfehlers mit einer veränderlichen Periodizität ausgeführt wird.

5. Verfahren nach Anspruch 2, **dadurch gekennzeichnet, dass** der geschätzte Frequenzfehler entsprechend einer Mehrzahl von Schätzungen des Frequenzfehlers gefiltert wird, derart, dass ein gemittelter Frequenzfehler erhalten wird.

6. Verfahren nach Anspruch 1, **dadurch gekennzeichnet, dass** der Qualitätsfaktor (qual_est) die Steuerung des Wirkungsgrades der Filterung der Kanalkoeffizienten ermöglicht.

7. Verfahren nach Anspruch 6, **dadurch gekennzeichnet, dass** der Qualitätsfaktor (qual_est) als Funktion eines Signal/Störungs-Verhältnisses bestimmt wird.

8. Vorrichtung zum Korrigieren des Frequenzfehlers, der in einem Mehrweg-Eingangssignal (data) eines Empfängers eines mobilen Funkkommunikationsendgeräts (REC), das mit einem entfernten Sender über einen Ausbreitungskanal kommunizieren kann, auftritt, **dadurch gekennzeichnet, dass** sie eine Zentraleinheit (6) umfasst, die dazu vorgesehen ist, drei verschiedene Behandlungsweisen für den Frequenzfehler auszuführen, die einer Behandlungsweise ohne jegliche Korrektur des Frequenzfehlers, einer Behandlungsweise mit offener Schleife für eine grobe Korrektur des Frequenzfehlers bzw. einer Behandlungsweise mit geschlossener Schleife für eine genaue Korrektur des Frequenzfehlers entsprechen, wobei die Behandlungsweise in Abhängigkeit einerseits von dem Wert des Frequenzfehlers und andererseits von einem durch eine Qualitätssteuereinheit (7) eines Blocks (3) zum Filtern der Kanalkoeffizienten bestimmten Qualitätsfaktor (qual_est) ausgewählt wird.

9. Vorrichtung nach Anspruch 8, **dadurch gekennzeichnet, dass** sie einen Block (4) zum Schätzen des Frequenzfehlers umfasst, dem ein Block (5) zum Filtern der Schätzung des Frequenzfehlers zugeordnet ist, um den Wert des Frequenzfehlers an die Zentraleinheit (6) zu liefern.

10. Vorrichtung nach einem der Ansprüche 8 oder 9, **dadurch gekennzeichnet, dass** sie außerdem für die Ausführung der groben Korrektur des Frequenzfehlers einerseits einen Block (9) für die Korrektur der Kanalschätzungen, der dazu vorgesehen ist, an den Block (3) für die Kanalfilterung eine Impulsantwort (CIR') des Ausbreitungskanals ohne Frequenzfehler zu liefern, und andererseits einen Block (10) für die Behandlung der Impulsantwort des Ausbreitungskanals, der dazu vorgesehen ist, den Frequenzfehler wieder in die gefilterte Impulsantwort (CIR") des Ausbreitungskanals einzuleiten, umfasst.

11. Vorrichtung nach einem der Ansprüche 8 oder 9, **dadurch gekennzeichnet, dass** sie darüber hinaus für die Ausführung der genauen Korrektur des Frequenzfehlers eine geschlossene Schleife, die aus einem Block (11) zum Filtern des gemittelten Frequenzfehlers, dem ein Frequenzkorrekturblock (12) zugeordnet ist, gebildet ist, wobei der Frequenzkorrekturblock (12) am Eingang das Mehrwegsignal (data) empfängt und am Ausgang ein Mehrwegsignal (data') ohne Frequenzfehler ausgibt.

REC

chercheur de trajets 1

estimateur de canal 2

DATA

CIR

estimation de fréquence $\varphi(t)$ 4

filtrage de $\varphi(t)$
$\varphi m(t)=\beta \varphi m(t-1)+(1-\beta).\varphi(t)$ 5

filtrage de canal 3

CIR'

circuit combineur 8

DATA'

CCU 6

qual_est

QCU 7

**Fig. 1**

EP 1 206 045 B1

Fig. 2

EP 1 206 045 B1

EP 1 206 045 B1

REC

chercheur
de
trajets ⌇1

8

12

correction
de fréquence
avec Φ(t)

DATA'

estimateur
de
canal ⌇2

CIR

estimation
de fréquence
résiduelle φ(t) ⌇4

circuit

combineur DATA''

DATA

filtrage de φ(t)
$\varphi m(t) = \beta \varphi m(t-1) + (1-\beta).\varphi(t)$ ⌇5

3

filtrage de $\varphi m(t)$
$\Phi(t) = \Phi(t-1) + \alpha \cdot \varphi m(t)$

filtrage
de
canal

CIR'

11

CCU

QCU

6

qual_est

7

## Fig. 3